(19) **Europäisches Patentamt / European Patent Office / Office européen des brevets**

(11) **EP 1 950 886 B1**

(12) **EUROPEAN PATENT SPECIFICATION**

(45) Date of publication and mention
of the grant of the patent:
**31.03.2010 Bulletin 2010/13**

(51) Int Cl.:
**H03L 7/093** (2006.01)

(21) Application number: **07001778.5**

(22) Date of filing: **26.01.2007**

(54) **Phase-locked loop transfer function optimization method and corresponding phase-locked loop circuit**

Verfahren zur Optimierung der Phasenregelkreis-Übertragungsfunktion und entsprechender Phasenregelkreis

Procédé d'optimisation de la fonction de transfert de boucle à verrouillage de phase et circuit correspondant de boucle à verrouillage de phase

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**30.07.2008 Bulletin 2008/31**

(73) Proprietor: **ADVA AG Optical Networking
82152 Martinsried (DE)**

(72) Inventors:
• **Williamson, John
York, YO24 3LT (GB)**
• **Turnbull,Peter
North Yorkshire HG5 9LZ (GB)**

(74) Representative: **Eder, Thomas et al
Eder & Schieschke,
Patentanwälte,
Elisabethstrasse 34
80796 München (DE)**

(56) References cited:
**US-A- 4 352 074     US-A- 5 036 298**

• **BLINCHIKOFF, H. ; VAUGHAN, G.: "ALL-Pole Phase-Locked Tracking Filters" IEEE TRANSACTIONS ON COMMUNICATIONS, vol. COM-30, no. 10, October 1982 (1982-10), XP007902421**
• **LEE T H ET AL: "A 155-MHZ CLOCK RECOVERY DELAY- AND PHASE-LOCKED LOOP" IEEE JOURNAL OF SOLID-STATE CIRCUITS, IEEE SERVICE CENTER, PISCATAWAY, NJ, US, vol. 27, no. 12, 1 December 1992 (1992-12-01), pages 1736-1746, XP000329023 ISSN: 0018-9200**

EP 1 950 886 B1

**Description**

The invention relates to a phase-locked loop circuitry structure, especially for use in a clock and data recovery device, comprising the features of the pre-characterizing part of claim 1.

Phase-locked loop circuits are widely used in the field of communication electronics, e.g. in the field of high-bitrate optical communication. PLLs are characterized by four elements: a phase detector, a low-pass filter (LPF), a voltage controlled oscillator (VCO), which can be modelled in the frequency domain as an integrator, and a means to feed the output back to the input so that deviations from desired conditions are continuously minimized and 'lock' is established. In order to provide the desired performance, the transfer function must provide filtering that occurs at a suitable cut-off frequency and sufficiently rejects frequencies above this cut-off. Usually, the sharper the roll-off, the better. However, to obtain a sharp roll-off, a high order LPF is usually required, which leads to comparably high costs. One way to gain sharp roll-off at low cost is to allow peaking in the frequency domain which leads to an underdamped time domain response. Unfortunately, such frequency domain peaking may lead to inadequate jitter performance especially when several of such PLLs are concatenated as would be the case in a telecommunications system.

US 5,036,298 discloses a voltage-controlled delay or phase shifter connected in series with a phase-locked loop where the voltage-controlled delay is controlled by the control voltage developed by the phase-locked amplifier and filter. With this arrangement the amplifier and filter can be designed to have a transfer function that does not include an explicit zero. Consequently, the jitter transfer function of the overall structure can be designed to remain equal to or less than unity over all frequencies and jitter peaking is eliminated.

In Lee, Th. H. et al, "A 155-MHz Clock Rcovery Delay- and Phase-Locked Loop", IEEE Journal of Solid-State Circuits, IEEE Service Center, Piscataway, NJ, US, Vol. 27, No. 12, December 1, 1992 a completely monolithic delay-locked loop (DLL) is described that may be used either by itself as a deskewing element, or in conjunction with an external voltage-controlled crystal oscillator to form a delay- and phase-locked loop (D/PLL). By phase shifting the input data rather than the clock, the DLL provide jitter-peaking-free clock recovery. The jitter transfer function of the D/PLL has a low band-with for good jitter filtering without compromising qcquisition speed. Also for realizing such a D/PLL a voltage-controlled phase shifting device is required.

Blinkikoff, H., Vaughan, G. Describe in "All-pole Phase-Locked Tracking Filters", IEEE Transactions on Communications, Vol. COM-30, No. 10, October 1982 the design and synthesis of second-, third, and fourth-order all-pole, phase-locked tracking filters for applications in which the signal-to-noise ratio is large. In order to duplicate a predetermined closed-loop transfer function being a normalized all-pole low-pass transfer function of order n the authors use a loop-filter having a transfer function of order n-1 and determine the filter coefficients for the general transfer function of a linear PLL model by comparing the coefficients of the corresponding polynoms of order n in the denominators of the predetermined transfer function and the PLL transfer function using the all-pole low-pass filter structure. This method uses loop filters having general all-pole filter transfer functions.

US 4,352,074 discloses a tunable narrow-band filter incorporating a phase-locked loop wherein the loop filter transfer function is derived or extracted from the desired closed-loop transfer function that is of oder n=3 or greater. The loop filter may have finite transmission zeroes or peak attenuation at specific frequencies close to the passband which also appear in the characteristic of the narrow-band filter. In this way, the problem of providing peak attenuation close to the passband of an electronically tunable narrow-band filter is overcome.

Starting from this prior art the object of the present invention to provide a phase-locked loop circuitry structure realizing an optimized transfer function which avoids peaking in the frequency domain and thus inducing jitter in the output signal and simultaneously provides an optimally sharp roll-off. Moreover, the present invention aims to providing a phase-locked loop circuitry structure, especially for use in a clock and data recovery device, having corresponding properties.

The invention achieves these objects with the combinations of features according to claim 1.

The invention uses the finding that amplifying no jitter in the time domain by simultaneously achieving an optimally sharp roll-off in the frequency domain is achievable by modelling the closed-loop transfer function of the PLL such that the transfer function is an all-pole function of the order n of the form $H(s)=K/(s+a)^n$, where K and a are design parameters determined at least by the low-pass filter means, where s is the complex frequency and where n is an integer number equal to or greater than 2. This results in a critically damped closed-loop transfer function and allows for an optimal compromise between frequency peaking and roll-off sharpness due to the pole of the order n.

According to an embodiment of the invention the transfer function of the low-pass filter means is modelled as an all-pole function of the order n-1.

In order to model the closed-loop transfer function, the transfer function of the phase detector means is described by an essentially frequency-independent constant $K_\phi$ and the transfer function of the voltage controlled oscillator means is described by a term $K_v/s$, where $K_v$ is an essentially frequency-independent constant. Together with the low-pass filter transfer function F(s) the closed-loop transfer function is defined by

$$\frac{V_o}{V_i} = \frac{F(s)\dfrac{K_V}{s}K_\phi}{\left(1 + F(s)\dfrac{K_V}{s}K_\phi\right)}$$

If the transfer function of the low-pass filter means is modelled as an all-pole function of the order n-1, this ensures simultaneously that the closed-loop transfer function is also an all-pole function (of the order n). The filter parameters may then be determined such that the closed-loop transfer function of the PLL reveals only one single pole of the order n.

In a preferred embodiment of the invention, the low-pass filter means comprise a first order passive low-pass filter consisting of a voltage divider consisting of a resistor $R_1$ and a parallel circuit of a resistor of a value $R_2$ and a capacitor of a value C and further comprise an operational amplifier circuit in the non-inverting basic circuit arrangement, the feedback impedance being a parallel circuit of a resistor of the value $R_2$ and a capacitor of the value C, and the grounding impedance being a resistor of the value $R_1$, where the voltage drop over the parallel circuit of the voltage divider forms the input voltage for the operational amplifier circuit so that the transfer function of the low-pass filter means F(s) equals

$$F(s) = \frac{R_2}{R_1(1 + sCR_2)}$$

If the values $R_1$ and $R_2$ and C of the resistors and the capacitor are chosen according to the relationships

$$R_1 C = \frac{(\sqrt{2}-1)K_\phi K_V}{\omega_c^2} \quad and \quad R_2 C = \frac{\sqrt{\sqrt{2}-1}}{2\omega_c}$$

the closed-loop transfer function reveals a single pole of the order 2 and thus avoids peaking and simultaneously provides the maximum sharpness of roll-off for a non-underdamped system.

Thus, the method according to the invention generally ensures that the optimum compromise between avoiding peaking and sharpness of the roll-off in the frequency domain may be established regardless of the desired cut-off frequency.

The afore-mentioned structure of a low-pass filter is very simple and may thus be realized at low cost.

Further embodiments of the invention are apparent from the dependent claims.

In the following the invention will be described with reference to the drawings, where

Fig. 1    shows a schematic representation of the closed-loop structure of a phase-locked loop circuitry;

Fig. 2    shows a circuit diagram of a first order low-pass filter according to the invention and

Fig. 3    shows a diagram showing the frequency-response curves of a known PLL with peaking in the frequency domain and of a PLL designed according to the present invention.

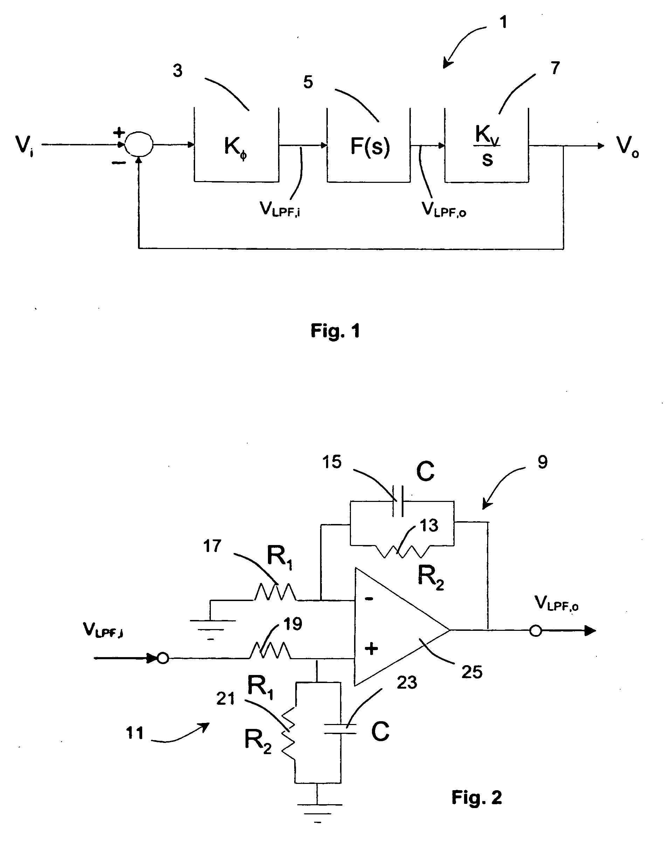

Fig. 1 shows a schematic block diagram of a phase-locked loop circuitry 1 consisting of a phase detector 3, which detects the phase difference of a reference input signal $V_i$ and a feedback signal $V_0$. In the frequency domain the phase detector 3 including the summation point may by described by an individual constant transfer function which equals a constant value $K_\phi$. The output signal of the phase detector 3 is fed as input signal $V_{LPF,i}$ to the input port of a low-pass filter 5 having the individual transfer function F(s). The low-pass filter output signal $V_{LPF,o}$ is fed to the input port of a voltage-controlled oscillator (VCO) 7 which is described by an individual transfer function equal to $K_V/s$, where $K_V$ is constant and s is the complex frequency. This means that in the frequency domain the VCO behaves like an integrator. The output signal $V_o$ of the VCO 7 is on the one hand the output signal of the whole circuit and can be used as recovered clock signal in a clock and data recovery circuit in a receiver included within a data transmission line. On the other hand, the output signal $V_o$ of the VCO 7 is fed back to the summation point and is there subtracted from the input reference signal $V_i$. Generally, the output signal of the phase detector 3 is a voltage corresponding to the phase difference of the reference input signal and the feedback signal.

Under the above assumptions the closed-loop transfer function of the PLL structure in Fig. 1 is determined as

$$\frac{V_o}{V_i} = \frac{F(s)\dfrac{K_V}{s}K_\phi}{\left(1 + F(s)\dfrac{K_V}{s}K_\phi\right)} \qquad (1)$$

As can be seen from equation (1), the closed-loop transfer function is essentially depending on the individual transfer function F(s) of the low-pass filter, where the closed-loop transfer function is an all-pole function of the order n if the denominator of the individual low-pass filter transfer function is a polynomial of the order n-1 (n being an integer number and n≥2). This,transfer function shows a maximum roll-off sharpness if its poles are identical, i.e. the closed-loop transfer function adopts the form $H(s)=K/(s+a)^n$.

If the low-pass filter is a first order filter, the transfer function of which is a first order all-pole function, the denominator of equation (1) becomes a polynomial of $2^{nd}$ order, which means that the poles of the closed-loop transfer function (being the roots of the polynomial) are identical, if the discriminant of the $2^{nd}$ order polynomial equals zero. This constraint can be used to determine the parameters of the first order low-pass filter.

Fig. 2 shows an example of a first order low-pass filter consisting of a non-inverting operational amplifier basic circuit arrangement 9 and a passive first order low-pass filter 11 in the form of a voltage divider, the output voltage of the voltage divider being fed to the positive input port of the operational amplifier 25.

The feedback impedance of the non-inverting operational amplifier basic circuit arrangement is a parallel circuit of a resistor 13 of the value $R_2$ and a capacitor 15 of the value C, and the grounding impedance is a resistor of the value $R_1$. The passive low-pass filter 11 consists of a resistor 19 of the value $R_1$ and a parallel circuit of a resistor 21 of the value $R_2$ and a capacitor 23 of the value C. The connection point of the resistor 19 and the parallel circuit of resistor 21 and capacitor 23 is connected to the positive input port of the operational amplifier 25. The individual transfer function of the low-pass filter means F(s) equals

$$F(s) = \frac{V_{LPF,o}}{V_{LPF,i}} = \frac{R_2}{R_1(1 + sCR_2)} \qquad (2)$$

where $V_{LPF,i}$ and $V_{LPF,o}$ are the filter input and output signals, respectively.

Using equation (2), the closed-loop transfer function according to equation (1) may be written as

$$\frac{V_o}{V_i} = \frac{\dfrac{K_V K_\phi}{R_1 C}}{\left(s^2 + \dfrac{1}{R_2 C}s + \dfrac{K_V K_\phi}{R_1 C}\right)} \qquad (3)$$

This $2^{nd}$ order all-pole function has a double pole and therefore adopts the form $H(s)=K/(s+a)^2$ with K equalling the numerator of equation (3) and $a=1/(2R_2C)$, if the discriminant of the $2^{nd}$ order polynomial of the denominator in equation (3) is zero. This results in the constraint

$$\left(\frac{1}{2R_2\,C}\right)^2=\frac{K_\phi\,K_V}{R_1\,C} \qquad (4)$$

Using the definition for the cut-off frequency $\omega_C$ requiring that the absolute value or modulus of the closed-loop transfer function equals $2^{-1/2}$ at the cut-off frequency $\omega_C$, a further constraint for the values $R_1$ and $R_2$ of the resistors 13, 17, 21 and the value C for the capacitors 15, 23 is obtained (for $s=\omega$):

$$\left|\frac{V_o}{V_i}\right|=\frac{\dfrac{K_V\,K_\phi}{R_1\,C}}{\sqrt{\left(\dfrac{K_V\,K_\phi}{R_1\,C}-\omega_C^{\,2}\right)^2+\left(\dfrac{1}{R_2\,C}\,\omega_C\right)^2}}:=\frac{1}{\sqrt{2}} \qquad (5)$$

The constraints according to relations (4) and (5) enable to determine the values $R_1$ and $R_2$ of the resistors 13, 17, 21 and the value C for the capacitors 15, 23 according to

$$R_1\,C=\frac{\left(\sqrt{2}-1\right)K_\phi\,K_V}{\omega_C^{\,2}} \quad and \quad R_2\,C=\frac{\sqrt{\sqrt{2}-1}}{2\,\omega_C} \qquad (6)$$

once the value of the cut-off frequency $\omega_C$ has been chosen. In order to determine the values $R_1$ and $R_2$, an arbitrary but convenient value C may be used.

Thus, by realizing a PLL with the first order low-pass filter structure shown in Fig. 2, the overall PLL transfer function or closed-loop transfer function becomes an all-pole second order low-pass filter. Through proper selection of the first order low-pass filter components, i.e. the proper selection of the values $R_1$, $R_2$ and C of the resistors 13, 17, 19, 21 and the capacitors 15, 23, the denominator polynomial of the PLL transfer function can be made factorable into a real, double pole. Since such a transfer function has a critically damped inverse Laplace transform, there will be no peaking in the frequency domain and thus amplifying any jitter in the time domain is avoided. Furthermore, the contributions that the first order low-pass filter components make to the coefficients of the PLL transfer function are readily separable. This means that the critically damped condition and the desired cut-off frequency can be simultaneously ensured.

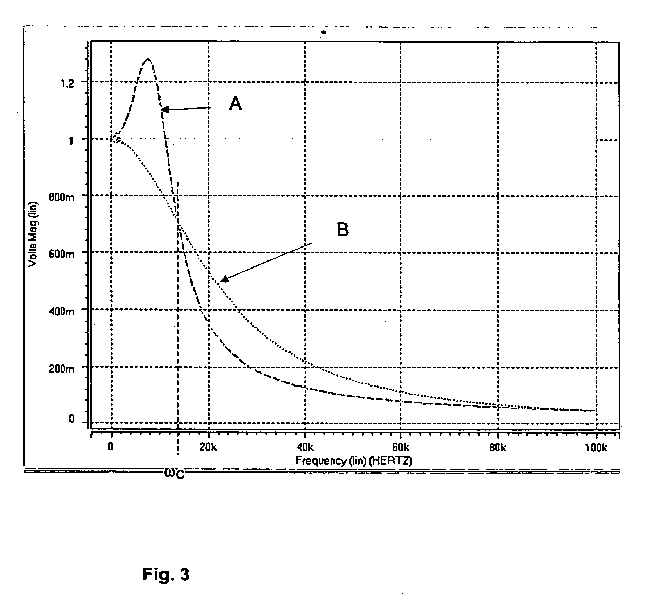

The two curves in Fig. 3 visualize the advantage of a PLL according to the invention (curve B) in comparison with a known PLL having an overall transfer function showing considerable peaking (curve A). Both curves show the absolute value of the transfer function versus frequency for PLL structures having the same cut-off frequency $\omega_C$.

In case the output of the phase detector is two signals instead of one signal and it is the potential difference of these two signals which includes the phase difference information of the reference input signal $V_i$ and the feedback signal $V_o$ the low-pass filter structure shown in Fig. 2 may be amended such that resistor 17 is not grounded. The grounded end of resistor 17 may then be used as input port for one of the output signals of the amended low-pass phase detector structure whereas the other output signal of the phase detector is still applied to the input port defined by resistor 19. As a result, the individual transfer function of the low-pass filter changes. However, the general design principle for an optimized PLL structure as described above including equation (1) remains the same.

## Claims

1.    A phase-locked loop circuitry structure, especially for use in a clock and data recovery device, the circuitry structure at least comprising

(a) concatenated in series phase detector means (3), low-pass filter means (5) and voltage controlled oscillator means (7), the phase detector means (3) providing an output signal ($V_o$) depending on the phase difference of a reference input signal and a feedback signal, and

(b) feedback means for feeding back the output signal ($V_o$) of said voltage controlled oscillator means (7) to said phase detector means (3) in order to minimize the phase difference of said reference input signal ($V_i$) and said feedback signal or to keep said phase difference to an essentially constant value, **characterized in**

(c) **that** the phase detector means (3), low-pass filter means (5) and voltage controlled oscillator means (7) have such individual transfer functions that the closed-loop transfer function H(s) of the phase-locked loop circuitry is an all-pole function of the order n of the form $H(s)=K/(s+a)^n$, where K and a are design parameters determined at least by the low-pass filter means (5),

where s is the complex frequency and where n is an integer number equal to or greater than 2.

2. A phase-locked loop circuitry according to claim 1, **characterized in that** the transfer function of the low-pass filter means (5) is an all-pole function of the order n-1.

3. A phase-locked loop circuitry according to one of claims 1 or 2, **characterized in that** the transfer function of the phase detector means (3) is described by an essentially frequency-independent constant $K_\phi$ and that the transfer function of the voltage controlled oscillator means (7) is described by a term $K_v/s$, where $K_v$ is an essentially frequency-independent constant.

4. A phase-locked loop circuitry according to one of the preceding claims, **characterized in that** the low-pass filter means (5) comprise a first order passive low-pass filter consisting of a voltage divider consisting of a resistor $R_1$ (19) and a parallel circuit of a resistor (21) of a value $R_2$ and a capacitor (23) of a value C and further comprise an operational amplifier circuit (25) in the non-inverting basic circuit arrangement, the feedback impedance being a parallel circuit of a resistor (13) of the value $R_2$ and a capacitor (15) of the value C and the grounding impedance being a resistor (17) of the value $R_1$, where the voltage drop over the parallel circuit of the voltage divider forms the input voltage for the operational amplifier circuit so that the individual transfer function of the low-pass filter means F(s) equals

$$F(s) = \frac{R_2}{R_1\left(1 + sCR_2\right)}$$

5. A phase-locked loop circuitry according to claims 3 and 4, **characterized in that** the values $R_1$, $R_2$ and C of the resistors (13, 17, 19, 21) and the capacitors (15, 23) are chosen according to the relationsships

$$R_1\,C = \frac{\left(\sqrt{2}-1\right)K_\phi\,K_v}{\omega_c^{\,2}} \qquad and \qquad R_2\,C = \frac{\sqrt{\sqrt{2}-1}}{2\,\omega_c}$$

where $\omega_C$ is a desired cut-off frequency.

**Patentansprüche**

1. Phasenregelkreis-Schaltungsstruktur, insbesondere zur Verwendung in einer Takt- und Datenrückgewinnungsvorrichtung, wobei die Schaltungsstruktur zumindest Folgendes aufweist:

a) in Reihe verbundene Phasendetektormittel (3), Tiefpassfiltermittel (5) und spannungsgesteuerte Oszillatormittel (7), wobei die Phasendetektormittel (3) abhängig von der Phasendifferenz eines Referenz-Eingangssignals und eines Rückkopplungssignals ein Ausgangssignal ($V_o$) liefern, und

b) Rückkopplungsmittel, um das Ausgangssignal ($V_o$) der spannungsgesteuerten Oszillatormittel (7) auf die Phasendetektormittel (3) rückzukoppeln, um die Phasendifferenz des Referenz-Eingangssignals ($V_i$) und des Rückkopplungssignals zu minimieren oder die Phasendifferenz auf einem im Wesentlichen konstanten Wert zu halten,

**dadurch gekennzeichnet,**

c) **dass** die Phasendetektormittel (3), Tiefpassfiltermittel (5) und spannungsgesteuerten Oszillatormittel (7) derartige individuelle Übertragungsfunktionen haben, dass die Übertragungsfunktion der geschlossenen Regelschleife H(s) der Phasenregelkreis-Schaltung eine Allpol-Funktion der Ordnung n der Form $H(s)=K/(s+a)^n$ ist, wobei K und a Entwurfsparameter sind, die zumindest durch die Tiefpassfiltermittel (5) bestimmt werden, wobei s die komplexe Frequenz ist und n eine ganze Zahl, die größer oder gleich 2 ist.

2. Phasenregelkreis-Schaltung nach Anspruch 1, **dadurch gekennzeichnet, dass** die Übertragungsfunktion der Tiefpassfiltermittel (5) eine Allpol-Funktion der Ordnung n-1 ist.

3. Phasenregelkreis-Schaltung nach einem der Ansprüche 1 oder 2, **dadurch gekennzeichnet, dass** die Übertragungsfunktion der Phasendetektormittel (3) durch eine im Wesentlichen frequenzunabhängige Konstante $K_\phi$ beschrieben wird, und dass die Übertragungsfunktion der spannungsgesteuerten Oszillatormittel (7) durch einen Term $K_V/s$ beschrieben wird, wobei $K_V$ eine im Wesentlichen frequenzunabhängige Konstante ist.

4. Phasenregelkreis-Schaltung nach einem der vorhergehenden Ansprüche, **dadurch gekennzeichnet, dass** die Tiefpassfiltermittel (5) ein passives Tiefpassfilter erster Ordnung aufweisen, das aus einem Spannungsteiler besteht, welcher aus einem Widerstand $R_1$ (19) und einer Parallelschaltung eines Widerstands (21) mit einem Wert $R_2$ und eines Kondensators (23) mit einem Wert C besteht, und dass sie außerdem eine Operationsverstärkerschaltung (25) in der nichtinvertierenden Grundschaltung aufweisen, wobei die Rückkopplungsimpedanz eine Parallelschaltung aus einem Widerstand (13) mit einem Wert $R_2$ und aus einem Kondensator (15) mit einem Wert C ist und die Masseimpedanz ein Widerstand (17) des Werts $R_1$ ist, wobei der Spannungsabfall über die Parallelschaltung des Spannungsteilers die Eingangsspannung für die Operationsverstärkerschaltung bildet, so dass die individuelle Übertragungsfunktion der Tiefpassfiltermittel F(s) gleich ist:

$$F(s) = \frac{R_2}{R_1(1+sCR_2)}$$

5. Phasenregelkreis-Schaltung nach den Ansprüchen 3 und 4, **dadurch gekennzeichnet, dass** die Werte $R_1$, $R_2$ und C der Widerstände (13, 17, 19, 21) und der Kondensatoren (15, 23) gemäß den Verhältnissen

$$R_1 C = \frac{(\sqrt{2}-1)K_\phi K_V}{\omega_C^2} \qquad und \qquad R_2 C = \frac{\sqrt{\sqrt{2}-1}}{2\omega_C}$$

gewählt werden, wobei $\omega_C$ eine gewünschte Grenzfrequenz ist.

**Revendications**

1. Structure d'éléments de circuit de boucle à verrouillage de phase, particulièrement destinée à une utilisation dans un dispositif de récupération d'horloge et de données, la structure d'éléments de circuit comprenant au moins :

(a) des moyens formant détecteur de phase (3), des moyens formant filtre passe-bas (5) et des moyens formant oscillateur commandé en tension (7) concaténés en série, les moyens formant détecteur de phase (3) fournissant un signal de sortie ($V_o$) fonction de la différence de phase d'un signal d'entrée de référence et d'un signal de rétroaction, et

(b) des moyens de rétroaction pour renvoyer le signal de sortie ($V_o$) desdits moyens formant oscillateur commandé en tension (7) auxdits moyens formant détecteur de phase (3) afin de réduire à un minimum la différence de phase dudit signal d'entrée de référence ($V_I$) et dudit signal de rétroaction ou de maintenir ladite différence de phase à une valeur essentiellement constante,

**caractérisée en ce que**

(c) les moyens formant détecteur de phase (3), les moyens formant filtre passe-bas (5) et les moyens formant oscillateur commandé en tension (7) ont des fonctions de transfert individuelles telles que la fonction de transfert en boucle fermée H(s) des éléments de circuit de boucle à verrouillage de phase est une fonction entièrement à pôles de l'ordre n de la forme $H(s) = K/(s+a)^n$, où K et a sont des paramètres de conception déterminés au moins par les moyens formant filtre passe-bas (5), où s est la fréquence complexe, et où n est un nombre entier égal ou supérieur à 2.

2. Eléments de circuit de boucle à verrouillage de phase selon la revendication 1, **caractérisés en ce que** la fonction de transfert des moyens formant filtre passe-bas (5) est une fonction entièrement à pôles de l'ordre n-1.

3. Eléments de circuit de boucle à verrouillage de phase selon l'une des revendications 1 et 2, **caractérisés en ce que** la fonction de transfert des moyens formant détecteur de phase (3) est décrite par une constante essentiellement indépendante de la fréquence $K_\phi$ **et en ce que** la fonction de transfert des moyens formant oscillateur commandé en tension (7) est décrite par un terme $K_v/s$, où $K_v$ est une constante essentiellement indépendante de la fréquence.

4. Eléments de circuit de boucle à verrouillage de phase selon l'une des revendications précédentes, **caractérisés en ce que** les moyens formant filtre passe-bas (5) comprennent un filtre passe-bas passif du premier ordre consistant en un diviseur de tension consistant en une résistance $R_1$ (19) et un circuit parallèle d'une résistance (21) d'une valeur $R_2$ et d'un condensateur (23) d'une valeur C et comprennent en outre un circuit d'amplificateur opérationnel (25) dans l'agencement de circuit de base non inverseur, l'impédance de rétroaction étant un circuit parallèle d'une résistance (13) de la valeur $R_2$ et d'un condensateur (15) de la valeur C et l'impédance de mise à la masse étant une résistance (17) de la valeur $R_1$, où la chute de tension sur le circuit parallèle du diviseur de tension forme la tension d'entrée pour le circuit d'amplificateur opérationnel de sorte que la fonction de transfert individuelle des moyens formant filtre passe-bas F(s) est égale à

$$F(s) = \frac{R_2}{R_1\left(1 + sCR_2\right)}$$

5. Eléments de circuit de boucle à verrouillage de phase selon les revendications 3 et 4, **caractérisés en ce que** les valeurs $R_1$, $R_2$ et C des résistances (13, 17, 19, 21) et des condensateurs (15, 23) sont choisies conformément aux relations

$$R_1 C = \frac{\left(\sqrt{2}-1\right)K_\phi K_v}{\omega_c^2} \qquad R_2 C = \frac{\sqrt{\sqrt{2}-1}}{2\,\omega_c}$$

et

où $\omega_C$ est une fréquence de coupure souhaitée.

**Fig. 1**

**Fig. 2**

**Fig. 3**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5036298 A

- US 4352074 A

**Non-patent literature cited in the description**

- **Lee, Th. H. et al.** A 155-MHz Clock Rcovery Delay-and Phase-Locked Loop. *IEEE Journal of Solid-State Circuits, IEEE Service Center,* 01 December 1992, vol. 27 (12

- **Blinkikoff, H. ; Vaughan, G.** All-pole Phase-Locked Tracking Filters. *IEEE Transactions on Communications,* October 1982, vol. COM-30 (10